# EUROPÄISCHE PATENTSCHRIFT

(11) **EP 2 649 647 B1**
(45) Veröffentlichungstag und Bekanntmachung des Hinweises auf die Patenterteilung: **26.07.2017**
(21) Anmeldenummer: 11776467.0
(22) Anmeldetag: 02.11.2011
(51) Int. Cl.: H01L 25/16, H01L 33/52, H01L 31/147

(54) **OPTOELEKTRONISCHES HALBLEITERBAUELEMENT, VERFAHREN ZU DESSEN HERSTELLUNG UND VERWENDUNG EINES DERARTIGEN BAUELEMENTS**
OPTO-ELECTRONIC SEMICONDUCTOR COMPONENT, METHOD FOR PRODUCING THE SAME AND USE OF SUCH A COMPONENT
COMPOSANT SEMI-CONDUCTEUR OPTOÉLECTRONIQUE, SON PROCÉDÉ DE FABRICATION ET UTILISATION D'UN TEL COMPOSANT

(30) Priorität: 08.12.2010 DE 102010053809
(43) Veröffentlichungstag der Anmeldung: 16.10.2013
(73) Patentinhaber: OSRAM Opto Semiconductors GmbH, 93055 Regensburg (DE)
(72) Erfinder: LURUTHUDASS, Annaniah, Penang 11900 (MY); VICKNES, Ratha Krishnan, Penang 6U-2-4 (MY)
(74) Vertreter: Epping - Hermann - Fischer
(86) Internationale Anmeldenummer: PCT/EP2011/069249
(87) Internationale Veröffentlichungsnummer: WO 2012/076258

(56) Entgegenhaltungen:
- EP-A1- 1 858 086
- DE-A1-102008 025 159
- DE-C1- 10 214 121
- JP-A- 2007 266 049
- US-A1- 2003 218 174
- US-A1- 2010 026 192

## Beschreibung

Die Erfindung betrifft ein optoelektronisches Bauelement mit einem Gehäuse, einem strahlungsemittierenden Halbleiterchip und einem strahlungsdetektierenden Halbleiterchip, ein Verfahren zur Herstellung eines derartigen Bauelements und eine Verwendung eines derartigen Bauelements.

Es ist bekannt, Bauelemente mit einem strahlungsemittierenden Halbleiterchip und einem strahlungsdetektierenden Halbleiterchip auszugestalten. Diese Vorrichtungen weisen jedoch herkömmlicherweise Halbleiterchips auf, die in separaten Gehäusen und separat voneinander auf beispielsweise einer Leiterplatte angeordnet sind. Dadurch benötigen derartige Vorrichtungen meist jedoch nachteilig einen großen Platzbedarf sowie groß ausgebildete Komponenten. Das wiederum spiegelt sich meist nachteilig in den Herstellungskosten und Bauelementkosten wider.

Die Druckschrift DE 102 14 121 C1 betrifft ein optoelektronisches Bauelement mit mehreren Halbleiterchips.

In der Druckschrift DE 10 2008 025 159 A1 finden sich ein Halbleiterbauelement und eine Reflexlichtschranke.

Ein Detektor mit mehreren emittierenden Halbleiterchips ist in der Druckschrift US 2003/0218174 A1 beschrieben.

Ein optoelektronisches Bauteil und ein Herstellungsverfahren hierfür sind in der Druckschrift EP 1 858 086 A1 offenbart. Angaben zu einem Fotosensor und zu einem Umgebungslichtsensor sind in der Druckschrift US 2010/0026192 enthalten.

Aus der Druckschrift JP 2007-266049 A ist ein optisches Kommunikationsmodul bekannt.

Es ist Aufgabe der vorliegenden Erfindung, ein Bauelement anzugeben, das kompakt ausgebildet ist und gleichzeitig flexibel auf Umwelteinflüsse reagiert. Weiter ist es Aufgabe der vorliegenden Erfindung, ein Herstellungsverfahren für ein derartiges Bauelement anzugeben, das kostengünstig ist. Zudem ist Aufgabe der Erfindung, eine flexible und gleichzeitig zuverlässige Verwendung derartiger Bauelemente anzugeben.

Diese Aufgaben werden durch ein Bauelement mit den Merkmalen des Anspruchs 1, durch eine Verwendung eines derartigen Bauelements mit den Merkmalen des Anspruchs 12 und durch ein Verfahren zum Herstellen eines derartigen Bauelements mit den Merkmalen des Anspruchs 14 gelöst. Vorteilhafte Weiterbildungen des Bauelements, dessen Verwendung und dessen Herstellungsverfahren sind Gegenstand der abhängigen Ansprüche.

Es weist das optoelektronische Halbleiterbauelement ein Gehäuse, einen strahlungsemittierenden Halbleiterchip und einen strahlungsdetektierenden Halbleiterchip auf. In dem Gehäuse sind eine erste Kavität und eine zweite Kavität ausgebildet. Der strahlungsemittierende Halbleiterchip weist eine zur Strahlungserzeugung geeignete aktive Schicht auf und ist in der ersten Kavität angeordnet, die mittels einer ersten Vergussmasse vergossen ist. Der strahlungsdetektierende Halbleiterchip weist zur Strahlungsdetektion geeignete aktive Schicht auf und ist in der zweiten Kavität angeordnet, die mittels einer zweiten Vergussmasse vergossen ist. In der zweiten Vergussmasse sind Absorberpartikel eingebettet, die geeignet sind, die von dem strahlungsemittierenden Halbleiterchip emittierte Strahlung zumindest teilweise zu absorbieren.

Der strahlungsemittierende Halbleiterchip und der strahlungsdetektierende Halbleiterchip sind somit in einem gemeinsamen Gehäuse integriert. Das ermöglicht insbesondere ein kompaktes Halbleiterbauelement, das sich durch eine geringe Größe auszeichnet, wodurch sich die Materialkosten mit Vorteil reduzieren. Aufgrund der Absorberpartikel in der zweiten Vergussmasse ist die Detektion der von dem strahlungsemittierenden Halbleiterchip emittierten Strahlung durch den strahlungsdetektierenden Halbleiterchip verhindert. So ermöglicht sich die Detektion lediglich externer Strahlung durch den strahlungsdetektierenden Halbleiterchip.

Der strahlungsemittierende Halbleiterchip und der strahlungsdetektierende Halbleiterchip beeinflussen sich somit im Betrieb kaum beziehungsweise nicht. So kann mit Vorteil ein Bauelement realisiert werden, das aufgrund des strahlungsdetektierenden Halbleiterchips flexibel auf beispielsweise Sonnenlicht reagiert, wobei gleichzeitig eine Beeinflussung der emittierten Strahlung des strahlungsemittierenden Halbleiterchips auf den strahlungsdetektierenden Halbleiterchip vermieden ist.

Der strahlungsemittierende Halbleiterchip weist eine Strahlungsaustrittsseite für die im Halbleiterchip erzeugte Strahlung auf. Aus der Strahlungsaustrittsseite wird vorzugsweise ein großer Anteil der im Chip erzeugten Strahlung ausgekoppelt. Auf der von der Strahlungsaustrittsseite gegenüberliegenden Seite weist der strahlungsemittierende Halbleiterchip eine Befestigungsseite auf, mit der der strahlungsemittierende Halbleiterchip in der ersten Kavität des Gehäuses angeordnet ist.

Der strahlungsdetektierende Halbleiterchip weist eine entsprechende Strahlungseintrittsseite für die im Halbleiterchip zu detektierenden Strahlung auf sowie eine der Strahlungseintrittsseite gegenüberliegenden Befestigungsseite, mit der der strahlungsdetektierende Halbleiterchip in der zweiten Kavität des Gehäuses angeordnet ist.

Die aktiven Schichten der Halbleiterchips enthalten jeweils vorzugsweise einen pn-Übergang, eine Doppelheterostruktur, eine Einfachquantentopfstruktur (SQW, single quantum well) oder eine Mehrfachquantentopfstruktur (MQW, multi quantum well).

Die Halbleiterchips weisen jeweils beispielsweise eine Halbleiterschichtenfolge auf, die jeweils die aktive Schicht enthalten. Die Halbleiterschichtenfolgen enthalten jeweils mindestens ein III/V-Halbleitermaterial.

Es ist der strahlungsdetektierende Halbleiterchip vorgesehen, Strahlung in einem Wellenlängenbereich zu detektieren, der von dem emittierenden Wellenlängenbereich des strahlungsemittierenden Halbleiterchips unterschiedlich ist.

Es ist der strahlungsemittierende Halbleiterchip dazu geeignet, Strahlung mit einer Wellenlänge im Bereich zwischen einschließlich 400 nm und 700 nm oder zwischen einschließlich 420 nm und 650 nm zu erzeugen. Zusätzlich ist der strahlungsdetektierende Halbleiterchip geeignet, IR-Strahlung mit einer Wellenlänge im Bereich zwischen einschließlich 800 nm und 1500 nm oder zwischen einschließlich 800 nm und 1050 nm oder zwischen einschließlich 840 nm und 920 nm zu detektieren. Es emittieren beziehungsweise detektieren die Halbleiterchips Strahlung ausschließlich in den angegebenen Wellenlängenbereichen.

Der strahlungsdetektierende Halbleiterchip ist somit empfindlich für Strahlung außerhalb des Wellenlängenbereichs der von dem strahlungsemittierenden Halbleiterchip emittierten Strahlung. So ermöglicht sich eine Detektion lediglich externer Strahlung durch den strahlungsdetektierenden Halbleiterchip, die unabhängig von der vom strahlungsemittierenden Halbleiterchip emittierte Strahlung ist.

In einer Weiterbildung erfolgt eine Bestromung des strahlungsemittierenden Halbleiterchips über den strahlungsdetektierenden Halbleiterchip. Der detektierende Halbleiterchip ist somit als Schalter zur Bestromung des strahlungsemittierenden Halbleiterchips vorgesehen. Abhängig vom strahlungsdetektierenden Halbleiterchip findet somit der Betrieb des strahlungsemittierenden Halbleiterchips statt, oder nicht.

Beispielsweise schaltet im Falle einfallender Strahlung der strahlungsemittierende Halbleiterchip dabei den strahlungsemittierenden Halbleiterchip aus. Detektiert der strahlungsdetektierende Halbleiterchip dagegen keine Strahlung beziehungsweise nur einen geringen Anteil an Strahlung, so schaltet dieser den strahlungsemittierenden Halbleiterchip an.

Es ist zwischen dem strahlungsemittierenden Halbleiterchip und dem strahlungsdetektierenden Halbleiterchip eine optische Barriere aufgrund der Kavitätwände ausgebildet. Die von dem strahlungsemittierenden Halbleiterchip emittierte Strahlung kann so nicht direkt von dem strahlungsdetektierenden Halbleiterchip detektiert werden. Sollte dennoch ein Anteil der von dem Halbleiterchip emittierte Strahlung in die Kavität des strahlungsdetektierenden Halbleiterchips gelangen, so wird dieser Anteil von den Absorberpartikeln im Vergussmaterial absorbiert, sodass auch dieser Anteil nicht bis zum strahlungsdetektierenden Halbleiterchip gelangt. So kann eine Beeinflussung der von dem strahlungsemittierenden Halbleiterchip emittierten Strahlung auf den strahlungsdetektierenden Halbleiterchip ausgeschlossen werden, sodass der strahlungsdetektierende Halbleiterchip zuverlässig auf einen externen Strahlungseinfall reagieren kann.

Aufgrund der Kavitätwände kann ein so genannter "Cross Talk" vermieden werden. Es ist also verhinderbar, dass von dem strahlungsemittierenden Halbleiterchip erzeugte Strahlung auf direktem Wege zu dem strahlungsdetektierenden Halbleiterchip gelangt. Bevorzugt trifft auch kein indirekt vom strahlungsemittierenden Halbleiterchip erzeugte Strahlung auf den strahlungsdetektierenden Halbleiterchip oder nur zu einem Anteil von höchstens 10-3 oder von höchstens 10⁻⁴.

In einer Weiterbildung sind die erste und die zweite Kavität des Gehäuses mittels eines integrierten Trennschlitzes mechanisch voneinander getrennt. Der Trennschlitz ist insbesondere zwischen den Kavitätwänden der ersten Kavität und der zweiten Kavität ausgebildet.

In einer Weiterbildung sind die erste Vergussmasse eine Silikonvergussmasse und die zweite Vergussmasse eine Epoxidharzvergussmasse. Die Vergussmassen über den Halbleiterchips können entsprechend gewünschter Anforderungen angepasst sein. So kann beispielsweise ein Vergussmaterial, das sensibel auf die zu detektierende Strahlung reagiert, als Vergussmaterial für die erste Kavität dienen. So kann das jeweilige Vergussmaterial hinsichtlich der Materialkosten und gewünschten Anforderungen entsprechend optimal angepasst sein.

Es ist der strahlungsemittierende Halbleiterchip eine LED, die geeignet ist, sichtbare Strahlung zu emittieren und der strahlungsdetektierende Halbleiterchip ist ein Fotodetektor, der geeignet ist, IR-Strahlung zu detektieren.

Der strahlungsemittierende Halbleiterchip ist dabei zur Beleuchtung geeignet. Der Fotodetektor detektiert dabei das externe Sonnenlicht, insbesondere die darin enthaltene einfallende IR-Strahlung. Im Falle einfallender IR-Strahlung schaltet der Detektor dabei die LED aus. Detektiert der Detektor dagegen keine IR-Strahlung, so schaltet dieser die LED an, sodass ein Bauelement realisiert werden kann, das flexibel auf Sonnenlicht reagiert.

In einer Weiterbildung sind in dem Gehäuse für die Halbleiterchips jeweils zwei Leiterplatten integriert, die mit Gehäusematerial umgossen sind. Die Leiterplatten sind insbesondere zur elektrischen Kontaktierung der Halbleiterchips vorgesehen. Insbesondere bilden die Leiterplatten jeweils zumindest bereichsweise Bodenflächen der ersten und zweiten Kavität aus, auf denen die Halbleiterchips jeweils direkt befestigt sind.

In einer Weiterbildung enthält das Gehäuse ein schwarz gefärbtes Epoxid. Dadurch kann mit Vorteil weiter eine Beeinflussung der von dem strahlungsemittierenden Halbleiterchip emittierten Strahlung auf den strahlungsdetektierenden Halbleiterchip verhindert werden.

In einer Weiterbildung ist das Gehäuse zumindest bereichsweise mit Nickel, Palladium und/oder Gold überzogen. Aufgrund eines derartigen Überzugs kann der Anteil der von den strahlungsemittierenden Halbleiterchips in Richtung Gehäuse oder Kavitätwände emittierte Anteil in Richtung Strahlungsaustrittsseite reflektiert werden.

In einer Weiterbildung ist das Gehäuse ein QFN-Gehäuse (quad flad no leads-Gehäuse). Derartige QFN-Gehäuse sind dem Fachmann bekannt und werden daher an dieser Stelle nicht näher erläutert.

Es findet das Halbleiterbauelement Verwendung als intelligente Lichtquelle, die abhängig von dem detektierten Anteil externer Strahlung den Betrieb des strahlungsemittierenden Halbleiterchips veranlasst. Unterschreitet der detektierte Anteil externer Strahlung einen gewissen Grenzwert, so schaltet der strahlungsdetektierende Halbleiterchip die Bestromung des strahlungsemittierenden Halbleiterchips an, sodass dieser sichtbare Strahlung emittiert, also als Lichtquelle dient. Liegt der detektierte Anteil externer Strahlung oberhalb des Grenzwertes, so schaltet der strahlungsdetektierende Halbleiterchip die Bestromung des strahlungsemittierenden Halbleiterchips aus, sodass der strahlungsemittierende Halbleiterchip keine Strahlung emittiert, wodurch die Lichtquelle nicht mehr im Betreib ist.

Die externe Strahlung ist beispielsweise Sonnenstrahlung, vorzugsweise Infrarotstrahlung.

Ein Verfahren zum Herstellen eines solchen optoelektronischen Halbleiterbauelements mit einem Gehäuse, einem strahlungsemittierenden Halbleiterchip und einem strahlungsdetektierenden Halbleiterchip umfasst folgende Verfahrensschritte:
- Bereitstellen des Gehäuses mit einer ersten Kavität und einer zweiten Kavität,
- Anordnen des strahlungsemittierenden Halbleiterchips in der ersten Kavität und Vergießen der ersten Kavität mittels einer ersten Vergussmasse,
- Anordnen des strahlungsdetektierenden Halbleiterchips in
der zweiten Kavität und Vergießen der zweiten Kavität mittels einer zweiten Vergussmasse, wobei in der zweiten Vergussmasse Absorberpartikel eingebettet sind, die geeignet sind, die von dem strahlungsemittierenden Halbleiterchip emittierte Strahlung zumindest teilweise zu absorbieren.

Die in Verbindung mit dem optoelektronischen Bauelement oder dessen Verwendung genannten Merkmale gelten auch für das Verfahren und umgekehrt.

Aufgrund der Anordnung der Halbleiterchips in einem gemeinsamen Gehäuse kann ein kostengünstiges Herstellungsverfahren realisiert werden, das sich insbesondere durch einen geringen Platzbedarf auszeichnet.

In einer Weiterbildung werden in einem gemeinsamen Verfahren eine Mehrzahl von Halbleiterbauelementen hergestellt, die anschließend mittels eines Sägeprozesses vereinzelt werden. Dadurch ermöglicht sich die Herstellung derartiger Halbleiterbauelemente im Massenprozess.

Weitere Vorteile und vorteilhafte Weiterbildungen der Erfindung ergeben sich aus den im Folgenden in Verbindung mit den Figuren 1 bis 4 beschriebenen Ausführungsbeispielen. Es zeigen:
- Figur 1A: einen schematischen Querschnitt eines Ausführungsbeispiels eines erfindungsgemäßen Bauelements,
- Figur 1B: eine schematische Schrägansicht des Ausführungsbeispiels zu Figur 1A,
- Figur 2: ein Schaltdiagramm zu dem Ausführungsbeispiel der Figur 1A,
- Figur 3A: eine Aufsicht auf das Ausführungsbeispiel zu Figur 1A,
- Figur 3B: eine Sicht auf die Unterseite des Ausführungsbeispiels zu Figur 1A, und
- Figur 4: ein Schaltdiagramm gemäß dem Stand der Technik.

In den Figuren können gleiche oder gleich wirkende Bestandteile jeweils mit den gleichen Bezugszeichen versehen sein. Die dargestellten Bestandteile und deren Größenverhältnisse untereinander sind grundsätzlich nicht als maßstabsgerecht anzusehen. Vielmehr können einzelne Bestandteile, wie zum Beispiel Schichten, Strukturen, Komponenten und Bereiche, zur besseren Darstellbarkeit und/oder zum besseren Verständnis übertrieben dick oder groß dimensioniert dargestellt sein.

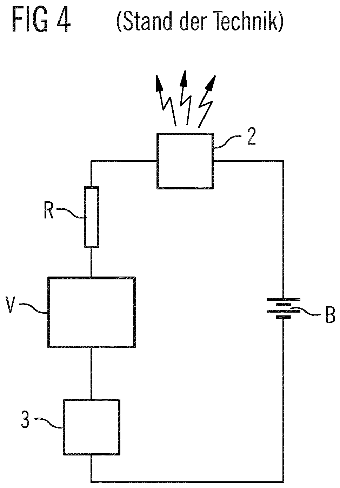

In Figur 4 ist ein Schaltdiagramm zu einem Bauelement gemäß dem Stand der Technik dargestellt. Ein derartiges Bauelement weist einen strahlungsemittierenden Halbleiterchip 2 und einen strahlungsdetektierenden Halbleiterchip 3 auf. Diese Halbleiterchips sind miteinander elektrisch leitend verbunden. Gemäß dem Stand der Technik sind die jeweiligen Halbleiterchips jedoch in separaten Einheiten beziehungsweise Gehäusen angeordnet. Die Gehäuse sind dabei separat und entfernt voneinander beispielsweise auf einer Leiterplatte angeordnet. Aufgrund der separaten Anordnung ist jedoch die Größe der Leiterplatte nicht kompakt ausgebildet.

Zwischen strahlungsemittierendem Halbleiterchip 2 und strahlungsdetektierendem Halbleiterchip 3 ist ein Widerstand R, ein Spannungsregler V und eine Sechsvoltbatterie B angeordnet.

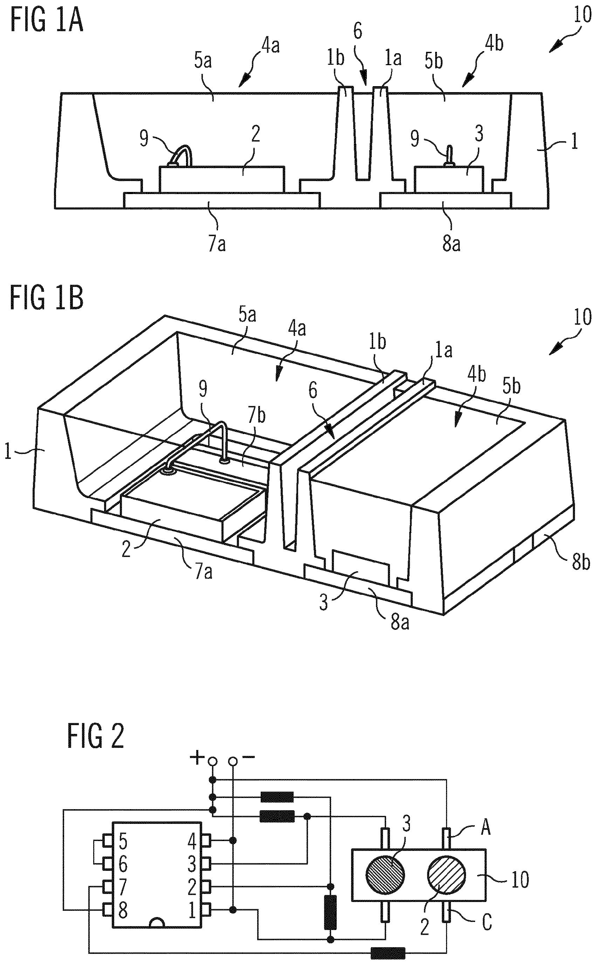

In Figur 1A ist ein Querschnitt eines erfindungsgemäßen Bauelements 10 dargestellt. Das erfindungsgemäße Bauelement 10 weist ein Gehäuse 1, einen strahlungsemittierenden Halbleiterchip 2 und einen strahlungsdetektierenden Halbleiterchip 3 auf.

Das Gehäuse 1 weist eine erste Kavität 4a und eine zweite Kavität 4b auf. Zwischen der ersten Kavität 4a und der zweiten Kavität 4b sind Kavitätswände la, 1b angeordnet. Die erste und zweite Kavität 4a, 4b sind beispielsweise als Durchbrüche durch das Gehäuse 1 ausgebildet. An einer Gehäuseunterseite sind in den Bodenbereichen der ersten und zweiten Kavitäten 4a, 4b jeweils Leiterplatten 7a, 8a angeordnet, sodass die Durchbrüche der ersten und zweiten Kavitäten 4a, 4b an der Unterseite des Gehäuses 1 verschlossen sind. Gehäusematerial des Gehäuses 1 ragt dabei teilweise auf eine Montageseite der Leiterplatten 7a, 8a, sodass die Leiterplatten 7a, 8a mit dem Gehäuse 1 mechanisch fest verbunden sind. Beispielsweise ist das Gehäuse 1 mit darin angeordneten Leiterplatten 7a, 8a ein vorgefertigtes Gehäuse, dem Fachmann auch bekannt unter dem Begriff "Premolded-Gehäuse".

In der ersten Kavität 4a, insbesondere auf der Montageseite der ersten Leiterplatte 7a, ist der strahlungsemittierende Halbleiterchip 2 angeordnet. Der strahlungsemittierende Halbleiterchip 2 ist eine LED, vorzugsweise eine Dünnfilm-LED. Der strahlungsemittierende Halbleiterchip 2 ist mit einer Unterseite auf der Montageseite der ersten Leiterplatte 7a mechanisch und elektrisch leitend verbunden. Mit einer zweiten Leiterplatte ist der Halbleiterchip 2 von seiner Oberseite mittels eines Bonddrahtes 9 elektrisch leitend verbunden, sodass eine elektrisch leitende Kontaktierung des strahlungsemittierenden Halbleiterchips 2 ermöglicht wird.

Entsprechendes gilt für den strahlungsdetektierenden Halbleiterchip 3, der ein Fotodetektor ist. Dieser Halbleiterchip ist in der zweiten Kavität 4b angeordnet und mit einer dritten Leiterplatte 8a elektrisch leitend und mechanisch verbunden. Die zweite Kontaktierung des strahlungsdetektierenden Halbleiterchips 3 erfolgt mittels eines Bonddrahtes 9 zu einer vierten Leiterplatte.

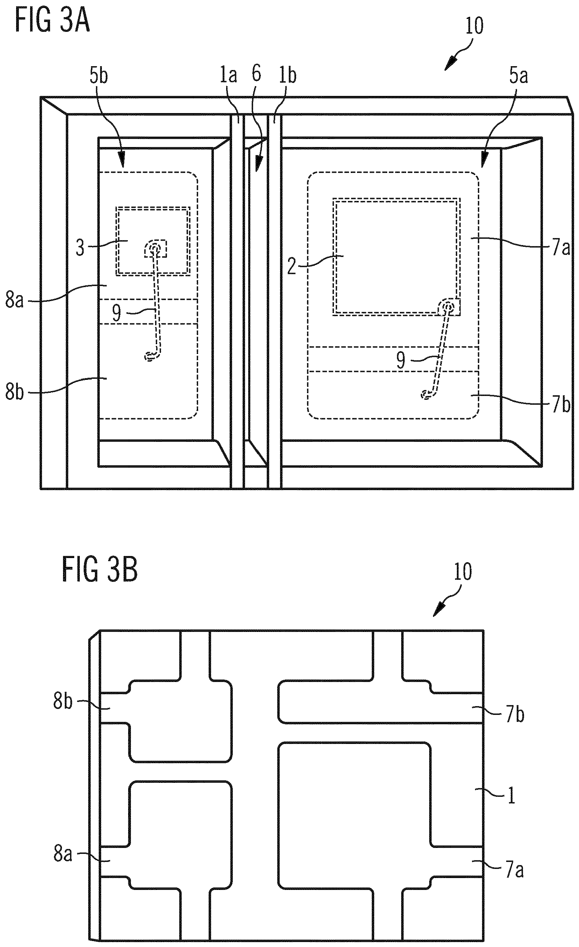

Die erste, zweite, dritte und vierte Leiterplatte sind beispielsweise in Verbindung mit .den Ausführungsbeispielen der Figuren 1B, 3A und 3B näher dargestellt und erläutert.

Die Höhen der ersten und zweiten Kavitäten 4a, 4b sind vorzugsweise größer als die Höhen der Halbleiterchips 2, 3. Das Gehäuse, insbesondere die Kavitätwände, überragen somit die Halbleiterchips 2, 3 vollständig. Aufgrund der Kavitätwände 1a, 1b ist so ein optisches Übergreifen der Halbleiterchips 2, 3 zueinander unterbunden. Es kann von dem strahlungsemittierenden Halbleiterchip 2 emittierte Strahlung nicht direkt von dem strahlungsdetektierenden Halbleiterchip 3 detektiert werden.

Der strahlungsemittierende Halbleiterchip 2 und der strahlungsdetektierende Halbleiterchip 3 weisen jeweils eine aktive Schicht auf. Die aktive Schicht der strahlungsemittierenden Halbleiterchips 2 ist geeignet zur Strahlungserzeugung. Die aktive Schicht des strahlungsdetektierenden Halbleiterchips 3 ist geeignet zur Strahlungsdetektion. Der strahlungsdetektierende Halbleiterchip 3 ist dazu vorgesehen, Strahlung in einem Wellenlängenbereich zu detektieren, der von dem emittierenden Wellenlängenbereich des strahlungsemittierenden Halbleiterchips 2 unterschiedlich ist. Dadurch ermöglicht sich, dass der strahlungsdetektierende Halbleiterchip nicht sensibel auf die von dem strahlungsemittierenden Halbleiterchip emittierte Strahlung reagiert.

Der strahlungsemittierende Halbleiterchip 2 ist eine LED, die geeignet ist, sichtbare Strahlung zu emittieren. Der strahlungsdetektierende Halbleiterchip 3 ist ein Fotodetektor, der geeignet ist, infrarote Strahlung zu detektieren.

Zwischen dem strahlungsemittierenden Halbleiterchip 2 und dem strahlungsdetektierenden Halbleiterchip 3 ist eine optische Barriere mittels der Kavitätwände la, 1b ausgebildet. So kann die von der LED emittierte Strahlung nicht direkt von dem Fotodetektor detektiert werden. Zwischen den Kavitätwänden 1a, 1b der ersten Kavität 4a und der zweiten Kavität 4b ist ein Trennschlitz ausgebildet, der die erste und die zweite Kavität 4a, 4b des Gehäuses 1 mechanisch voneinander trennt. Das Gehäuse 1 ist trotz des Trennschlitzes 6 einstückig ausgebildet.

In der ersten Kavität 4a ist der strahlungsemittierende Halbleiterchip 2 mittels einer Silikonvergussmasse vergossen. Der strahlungsdetektierende Halbleiterchip 3 ist in der zweiten Kavität 4b mittels einer Epoxidharzvergussmasse vergossen, wobei die Epoxidharzvergussmasse 5b Absorberpartikel umfasst, die geeignet sind, die von dem strahlungsemittierenden Halbleiterchip 2 emittierte Strahlung zumindest teilweise zu absorbieren. Sollte die von dem strahlungsemittierenden Halbleiterchip 2 emittierte Strahlung in die zweite Kavität 4b gelangen, so wird dieser Anteil der Strahlung von den Absorberpartikeln der Epoxidharzvergussmasse 5b absorbiert, sodass dieser Anteil nicht bis zum strahlungsdetektierenden Halbleiterchip 3 gelangt. Eine Beeinflussung des Strahlungsdetektors 3 durch die von der LED 2 emittierten Strahlung kann so verhindert werden.

Die Silikonvergussmasse 5a und die Epoxidharzvergussmasse 5b füllen dabei die erste Kavität 4a und die zweite Kavität 4b vollständig aus, sodass das Bauelement 10 eine vorzugsweise im Wesentlichen planare Oberfläche aufweist.

Das Gehäuse 1 enthält vorzugsweise ein schwarz gefärbtes Epoxid und ist zumindest bereichsweise mit Nickel, Palladium und/oder Gold überzogen. Beispielsweise ist das Gehäuse ein QFN-Gehäuse.

Eine Bestromung des strahlungsemittierenden Halbleiterchips 2 erfolgt über den strahlungsdetektierenden Halbleiterchip. Der detektierende Halbleiterchip ist somit als Schalter zur Bestromung des emittierenden Halbleiterchips und somit zum Betrieb des emittierenden Halbleiterchips ausgebildet. So kann eine intelligente Lichtquelle erzeugt werden, die abhängig von dem detektierenden Anteil externer Strahlung den Betrieb des strahlungsemittierenden Halbleiterchips 2 veranlasst. Als externe Strahlung wird beispielsweise Sonnenstrahlung angesehen. Detektiert somit der strahlungsdetektierende Halbleiterchip 3 Strahlung im infraroten Wellenlängenbereich oberhalb eines gewissen Grenzwertes, so schaltet der Strahlungsdetektor 3 die Bestromung des strahlungsemittierenden Halbleiterchips 2 aus, sodass dieser keine Strahlung emittiert. Das wäre beispielsweise der Fall, wenn in der Umgebung des Bauelements 10 Sonnenstrahlen in einem gewissen Anteil vorliegen, sodass eine Beleuchtung mittels des Bauelements 10 nicht notwendig ist.

Detektiert der Strahlungsdetektor 3 dagegen einen Anteil an externer Strahlung unterhalb eines bestimmten Grenzwertes, so schaltet der Strahlungsdetektor 3 die Bestromung des strahlungsemittierenden Halbleiterchips 2 an, sodass dieser Strahlung emittiert. Das ist beispielsweise der Fall, wenn der Anteil der externen Sonnenstrahlen abnimmt, beispielsweise bei Nacht, sodass eine Lichterzeugung durch das Bauelement notwendig ist.

Aufgrund der gemeinsamen Anordnung der Halbleiterchips 2, 3 kann ein kompaktes Bauelement 10 realisiert werden, das zuverlässig betreibbar ist und günstig in den Herstellungs- und Bauelementkosten ist.

Ein derartiges Bauelement 10 kann in einem Massenverfahren hergestellt werden, indem die Herstellung einer Mehrzahl derartiger Bauelemente gemeinsam erfolgt, die anschließend mittels beispielsweise Sägens vereinzelt werden.

In Figur 1B ist eine Schrägansicht eines Bauelements 10 beispielsweise gemäß dem Ausführungsbeispiel der Figur 1A dargestellt. An der Bodenfläche der ersten Kavität 4a ist die erste Leiterplatte 7a und die zweite Leiterplatte 7b angeordnet, mittels derer der strahlungsemittierende Halbleiterchip 2 elektrisch kontaktierbar ist. Entsprechendes gilt für den strahlungsdetektierenden Halbleiterchip 3, der auf einer dritten Leiterplatte 8a angeordnet und elektrisch leitend verbunden ist und dessen zweite Kontaktierung mittels einer vierten Leiterplatte 8b erfolgt. Der Trennungsschlitz 6 zwischen den Kavitätwänden 1a, 1b kann frei von Vergussmasse sein. Alternativ kann in dem Trennungsschlitz 6 zudem Vergussmasse beispielsweise der ersten Kavität 4a oder der zweiten Kavität 4b eingebracht sein. Die Strahlungsaustrittsseite der von dem strahlungsemittierenden Halbleiterchip 2 emittierten Strahlung aus dem Bauelement 10 erfolgt dabei von der Unterseite gegenüberliegenden Seite.

Im Übrigen stimmt das Ausführungsbeispiel der Figur 1B mit dem Ausführungsbeispiel der Figur 1A im Wesentlichen überein.

In Figur 2 ist ein Schaltdiagramm beispielsweise eines Bauelements 10 gemäß dem Ausführungsbeispiel der Figur 1A dargestellt. Die Halbleiterchips 2, 3 sind, wie in dem Schaltdiagramm dargestellt, in einem gemeinsamen Gehäuse angeordnet und elektrisch leitend miteinander verbunden. An dem Ein- und Ausgang der Halbleiterchips 2, 3 ist jeweils eine Anode A beziehungsweise Kathode C angeschlossen. Die Halbleiterchips 2, 3 sind mittels verschiedener elektrischer Komponenten miteinander verschaltet.

In dem Ausführungsbeispiel der Figur 3A ist eine Aufsicht auf beispielsweise ein Bauelement 10 gemäß dem Ausführungsbeispiel der Figur 1A dargestellt. In Aufsicht auf die erste Kavität und die zweite Kavität sind die Leiterplatten 7a, 7b, 8a, 8b sichtbar, die zur elektrischen Kontaktierung der Halbleiterchips 2, 3 dienen. Die einzelnen Leiterplatten 7a, 7b, 8a, 8b sind voneinander elektrisch isoliert angeordnet. Insbesondere ist zwischen den einzelnen Leiterplatten elektrisch isolierenden Gehäusematerial angeordnet.

Die Kavitäten sind von den Kavitätswänden vollständig umschlossen. Zwischen den beiden Kavitäten ist der Trennschlitz 6 angeordnet, der in diesem Ausführungsbeispiel frei von Vergussmaterial ist.

Im Übrigen stimmt das Ausführungsbeispiel der Figur 3A mit dem Ausführungsbeispiel der Figur 1A überein.

In Figur 3B ist eine Unteransicht auf ein Bauelement 10 gemäß dem Ausführungsbeispiel der Figur 3A dargestellt. Von der Unterseite her sind die einzelnen Leiterplatten 7a, 7b, 8a, 8b sichtbar, die zur elektrischen Kontaktierung der Halbleiterchips 2, 3 dienen. Die Leiterplatten sind elektrisch voneinander isoliert angeordnet. Insbesondere sind die einzelnen Leiterplatten in einem Abstand zueinander angeordnet, der mit Gehäusematerial 1 gefüllt ist. Das Bauelement 10 ist von seiner Unterseite her extern elektrisch kontaktierbar, in dem beispielsweise die Unterseite auf einer externen Leiterplatte montiert und mit dieser elektrisch leitend verbunden wird. Das Bauelement 10 ist insbesondere ein oberflächenmontierbares Bauelement.

Im Übrigen stimmt das Ausführungsbeispiel der Figur 3B mit dem Ausführungsbeispiel der Figur 3A überein.

Die Erfindung ist nicht durch die Beschreibung anhand der Ausführungsbeispiele auf diese beschränkt.

Diese Patentanmeldung beansprucht die Priorität der deutschen Patentanmeldung 10 2010 053 809.4.

## Patentansprüche

1. Optoelektronisches Halbleiterbauelement (10) mit einem Gehäuse (1), einem strahlungsemittierenden Halbleiterchip (2) und einem strahlungsdetektierenden Halbleiterchip (3), wobei
- in dem Gehäuse (1) eine erste Kavität (4a) und eine zweite Kavität (4b) ausgebildet sind, sodass zwischen dem strahlungsemittierenden Halbleiterchip (2) und dem strahlungsdetektierenden Halbleiterchip (3) eine optische Barriere aufgrund von Kavitätwänden (1a, 1b) ausgebildet ist,
- der strahlungsemittierende Halbleiterchip (2) eine zur Strahlungserzeugung geeignete aktive Schicht aufweist und in der ersten Kavität (4a) angeordnet ist, die mittels einer ersten Vergussmasse (5a) vergossen ist, und
- der strahlungsdetektierende Halbleiterchip (3) eine zur Strahlungsdetektion geeignete aktive Schicht aufweist und in der zweiten Kavität (4b) angeordnet ist, die mittels einer zweiten Vergussmasse (5b) vergossen ist,
**dadurch gekennzeichnet, dass**
- in der zweiten Vergussmasse (5b) Absorberpartikel eingebettet sind, die geeignet sind, die von dem strahlungsemittierenden Halbleiterchip (2) emittierte Strahlung zumindest teilweise zu absorbieren,
- der strahlungsemittierende Halbleiterchip (2) eine LED ist, die geeignet ist, sichtbare Strahlung mit einer Wellenlänge in einem Bereich zwischen einschließlich 400 nm und 700 nm zu emittieren und der strahlungsdetektierende Halbleiterchip (3) ein Fotodetektor ist, der geeignet ist, IR-Strahlung mit einer Wellenlänge im Bereich zwischen einschließlich 800 nm und 1500 nm zu detektieren, und
- der strahlungsemittierende Halbleiterchip (2) und der strahlungsdetektierende Halbleiterchip (3) ausschließlich in den angegebenen Wellenlängenbereichen emittieren beziehungsweise detektieren.

2. Halbleiterbauelement nach Anspruch 1, wobei der strahlungsdetektierende Halbleiterchip (3) vorgesehen ist, nur Strahlung in einem Wellenlängenbereich zu detektieren, der von dem Wellenlängenbereich der emittierten Strahlung des strahlungsemittierenden Halbleiterchips (2) unterschiedlich ist.

3. Halbleiterbauelement nach einem der vorhergehenden Ansprüche, wobei
eine Bestromung des strahlungsemittierenden Halbleiterchips (2) über den strahlungsdetektierenden Halbleiterchip (3) erfolgt.

4. Halbleiterbauelement nach einem der vorhergehenden Ansprüche, wobei
die erste und die zweite Kavität (4a, 4b) des Gehäuses (1) mittels eines integrierten Trennschlitzes (6) mechanisch voneinander getrennt sind.

5. Halbleiterbauelement nach dem vorhergehenden Anspruch, wobei
das Gehäuse (1) trotz des Trennschlitzes (6) einstückig ausgebildet ist.

6. Halbleiterbauelement nach einem der vorhergehenden Ansprüche, wobei
die erste Vergussmasse (5a) eine Silikon-Vergussmasse und die zweite Vergussmasse (5b) eine Epoxidharz-Vergussmasse sind.

7. Halbleiterbauelement nach einem der vorhergehenden Ansprüche, wobei
in dem Gehäuse (1) für den strahlungsemittierenden Halbleiterchip (2) und den strahlungsdetektierenden Halbleiterchip (3) jeweils zwei Leiterplatten (7a, 7b, 8a, 8b) integriert sind, die mit Gehäusematerial umgossen sind.

8. Halbleiterbauelement nach einem der vorhergehenden Ansprüche, wobei
das Gehäuse (1) ein schwarz gefärbtes Epoxid enthält.

9. Halbleiterbauelement nach einem der vorhergehenden Ansprüche, wobei
das Gehäuse (1) zumindest bereichsweise mit Nickel, Paladium und/oder Gold überzogen ist.

10. Halbleiterbauelement nach einem der vorhergehenden Ansprüche, wobei
der strahlungsemittierende Halbleiterchip (2) dazu eingerichtet ist, im Betrieb nur Strahlung mit einer Wellenlänge in einem Bereich zwischen einschließlich 420 nm und 650 nm zu erzeugen, und der strahlungsdetektierende Halbleiterchip (3) geeignet ist, nur Strahlung mit einer Wellenlänge im Bereich zwischen einschließlich 800 nm und 1050 nm zu detektieren.

11. Halbleiterbauelement nach einem der vorhergehenden Ansprüche, wobei
das Gehäuse (1) ein QFN-Gehäuse ist.

12. Verwendung eines Halbleiterbauelements (10) nach einem der vorhergehenden Ansprüche als intelligente Lichtquelle,
die abhängig von dem detektierten Anteil externer Strahlung den Betrieb des strahlungsemittierenden Halbleiterchips (2) veranlasst.

13. Verwendung nach Anspruch 12, wobei
die externe Strahlung Sonnenstrahlung ist.

14. Verfahren, mit dem ein optoelektronisches Halbleiterbauelement (10) nach einem der Ansprüche 1 bis 11 hergestellt wird, mit folgenden Verfahrensschritten:
- Bereitstellen des Gehäuses (1) mit der ersten Kavität (4a) und der zweiten Kavität (4b),
- Anordnen des strahlungsemittierenden Halbleiterchips (2) in der ersten Kavität (4a) und Vergießen der ersten Kavität (4a) mittels der ersten Vergussmasse (5a),
- Anordnen des strahlungsdetektierenden Halbleiterchips (3) in der zweiten Kavität (4b) und Vergießen der zweiten Kavität (4b) mittels der zweiten Vergussmasse (5b), wobei in der zweiten Vergussmasse (5b) die Absorberpartikel eingebettet sind.

15. Verfahren nach Anspruch 14, wobei
in einem gemeinsamen Verfahren mehrere der Halbleiterbauelemente (10) hergestellt werden, die anschließend mittels Sägen vereinzelt werden.

## Claims

1. Optoelectronic semiconductor component (10) comprising a housing (1), a radiation-emitting semiconductor chip (2) and a radiation-detecting semiconductor chip (3), wherein
- a first cavity (4a) and a second cavity (4b) are formed in the housing (1), so that an optical barrier on the basis of cavity walls (1a, 1b) is formed between the radiation-emitting semiconductor chip (2) and the radiation-detecting semiconductor chip (3),
- the radiation-emitting semiconductor chip (2) has an active layer suitable for generating radiation and is arranged in the first cavity (4a), which is potted by means of a first potting component (5a), and
- the radiation-detecting semiconductor chip (3) has an active layer suitable for detecting radiation and is arranged in the second cavity (4b), which is potted by means of a second potting compound (5b),
**characterized in that**
- absorber particles are embedded in the second potting compound (5b), said absorber particles being suitable for at least partly absorbing the radiation emitted by the radiation-emitting semiconductor chip (2),
- the radiation-emitting semiconductor chip (2) is an LED suitable for emitting visible radiation having a wavelength in a range of between 400 nm and 700 nm inclusive and the radiation-detecting semiconductor chip (3) is a photodetector suitable for detecting IR radiation having a wavelength in the range of between 800 nm and 1500 nm inclusive, and
- the radiation-emitting semiconductor chip (2) and the radiation-detecting semiconductor chip (3) emit and detect, respectively, exclusively in the wavelength ranges indicated.

2. Semiconductor component according to Claim 1, wherein the radiation-detecting semiconductor chip (3) is provided for detecting only radiation in a wavelength range that differs from the wavelength range of the emitted radiation of the radiation-emitting semiconductor chip (2).

3. Semiconductor component according to either of the preceding claims, wherein
the radiation-emitting semiconductor chip (2) is energized via the radiation-detecting semiconductor chip (3).

4. Semiconductor component according to any of the preceding claims, wherein
the first and second cavities (4a, 4b) of the housing (1) are mechanically separated from one another by means of an integrated separating slot (6).

5. Semiconductor component according to the preceding claim, wherein
the housing (1) is embodied integrally despite the separating slot (6).

6. Semiconductor component according to any of the preceding claims, wherein
the first potting compound (5a) is a silicone potting compound and the second potting compound (5b) is an epoxy resin potting compound.

7. Semiconductor component according to any of the preceding claims, wherein
in each case two printed circuit boards (7a, 7b, 8a, 8b) encapsulated with housing material by molding are integrated in the housing (1) for the radiation-emitting semiconductor chip (2) and the radiation-detecting semiconductor chip (3).

8. Semiconductor component according to any of the preceding claims, wherein
the housing (1) contains a black colored epoxide.

9. Semiconductor component according to any of the preceding claims, wherein
the housing (1) is coated with nickel, palladium and/or gold at least in regions.

10. Semiconductor component according to any of the preceding claims, wherein
the radiation-emitting semiconductor chip (2) is designed to generate only radiation having a wavelength in a range of between 420 nm and 650 nm inclusive during operation, and the radiation-detecting semiconductor chip (3) is suitable for detecting only radiation having a wavelength in the range of between 800 nm and 1050 nm inclusive.

11. Semiconductor component according to any of the preceding claims, wherein
the housing (1) is a QFN housing.

12. Use of a semiconductor component (10) according to any of the preceding claims as an intelligent light source, which instigates the operation of the radiation-emitting semiconductor chip (2) depending on the detected portion of external radiation.

13. Use according to Claim 12, wherein
the external radiation is solar radiation.

14. Method by which an optoelectronic semiconductor component (10) according to any of Claims 1 to 11 is produced, comprising the following method steps:
- providing the housing (1) having the first cavity (4a) and the second cavity (4b),
- arranging the radiation-emitting semiconductor chip (2) in the first cavity (4a) and potting the first cavity (4a) by means of the first potting compound (5a),
- arranging the radiation-detecting semiconductor chip (3) in the second cavity (4b) and potting the second cavity (4b) by means of the second potting compound (5b), wherein the absorber particles are embedded in the second potting compound (5b).

15. Method according to Claim 14, wherein
a plurality of the semiconductor components (10) are produced in a common method, said semiconductor components subsequently being singulated by means of sawing.

## Revendications

1. Composant semiconducteur optoélectronique (10) comprenant un boîtier (1), une puce semiconductrice d'émission de rayonnement (2) et une puce semiconductrice de détection de rayonnement (3),
- une première cavité (4a) et une deuxième cavité (4b) étant formées dans le boîtier (1), de sorte qu'une barrière optique est formée entre la puce semiconductrice d'émission de rayonnement (2) et la puce semiconductrice de détection de rayonnement (3) en raison de parois de cavité (1a, 1b),
- la puce semiconductrice d'émission de rayonnement (2) possédant une couche active adaptée à la génération de rayonnement et étant disposée dans la première cavité (4a), laquelle est scellée au moyen d'une première masse de scellement (5a), et
- la puce semiconductrice de détection de rayonnement (3) possédant une couche active adaptée à la détection de rayonnement et étant disposée dans la deuxième cavité (4b), laquelle est scellée au moyen d'une deuxième masse de scellement (5b),
**caractérisé en ce que**
- des particules absorbantes sont enrobées dans la deuxième masse de scellement (5b), lesquelles sont adaptées pour absorber au moins partiellement le rayonnement émis par la puce semiconductrice d'émission de rayonnement (2),
- la puce semiconductrice d'émission de rayonnement (2) est une LED qui est adaptée pour émettre un rayonnement visible ayant une longueur d'onde dans une plage comprise entre 400 nm et 700 nm inclus et
- la puce semiconductrice de détection de rayonnement (3) est un photodétecteur qui est adapté pour détecter un rayonnement IR ayant une longueur d'onde dans une plage comprise entre 800 nm et 1500 nm inclus et
- la puce semiconductrice d'émission de rayonnement (2) et la puce semiconductrice de détection de rayonnement (3) émettent et détectent exclusivement dans les plages de longueurs d'onde indiquées.

2. Composant semiconducteur selon la revendication 1, la puce semiconductrice de détection de rayonnement (3) étant destinée à ne détecter le rayonnement que dans une plage de longueurs d'onde qui est différente de la plage de longueurs d'onde du rayonnement émis de la puce semiconductrice d'émission de rayonnement (2).

3. Composant semiconducteur selon l'une des revendications précédentes, une alimentation électrique de la puce semiconductrice d'émission de rayonnement (2) s'effectuant par le biais de la puce semiconductrice de détection de rayonnement (3).

4. Composant semiconducteur selon l'une des revendications précédentes, les première et deuxième cavités (4a, 4b) du boîtier (1) étant séparées mécaniquement l'une de l'autre au moyen d'une fente de séparation (6) intégrée.

5. Composant semiconducteur selon l'une des revendications précédentes, le boîtier (1) étant réalisé d'un seul tenant malgré la fente de séparation (6).

6. Composant semiconducteur selon l'une des revendications précédentes, la première masse de scellement (5a) étant une masse de scellement à base de silicone et la deuxième masse de scellement (5b) une masse de scellement à base de résine époxy.

7. Composant semiconducteur selon l'une des revendications précédentes, deux circuits imprimés (7a, 7b, 8a, 8b) qui sont surmoulés avec le matériau du boîtier étant respectivement intégrés dans le boîtier (1) pour la puce semiconductrice d'émission de rayonnement (2) et la puce semiconductrice de détection de rayonnement (3).

8. Composant semiconducteur selon l'une des revendications précédentes, le boîtier (1) contenant un époxy teint en noir.

9. Composant semiconducteur selon l'une des revendications précédentes, le boîtier (1) étant, au moins dans certaines zones, enduit de nickel, de palladium et/ou d'or.

10. Composant semiconducteur selon l'une des revendications précédentes, la puce semiconductrice d'émission de rayonnement (2) étant conçue pour, en fonctionnement, émettre uniquement un rayonnement ayant une longueur d'onde dans une plage comprise entre 420 nm et 650 nm inclus et la puce semiconductrice de détection de rayonnement (3) étant adaptée pour détecter uniquement un rayonnement ayant une longueur d'onde dans une plage comprise entre 800 nm et 1050 nm inclus.

11. Composant semiconducteur selon l'une des revendications précédentes, le boîtier (1) étant un boîtier de type QFN.

12. Application d'un composant semiconducteur (10) selon l'une des revendications précédentes sous la forme d'une source de lumière intelligente qui provoque le fonctionnement de la puce semiconductrice d'émission de rayonnement (2) en fonction de la part détectée d'un rayonnement externe.

13. Application selon la revendication 12, le rayonnement externe étant le rayonnement solaire.

14. Procédé de fabrication d'un composant semiconducteur optoélectronique (10) selon l'une des revendications 1 à 11, comprenant les étapes suivantes :
- fourniture du boîtier (1) pourvu de la première cavité (4a) et de la deuxième cavité (4b) ,
- disposition de la puce semiconductrice d'émission de rayonnement (2) dans la première cavité (4a) et scellement de la première cavité (4a) au moyen de la première masse de scellement (5a),
- disposition de la puce semiconductrice de réception de rayonnement (3) dans la deuxième cavité (4b) et scellement de la deuxième cavité (4b) au moyen de la deuxième masse de scellement (5b), les particules absorbantes étant enrobées dans la deuxième masse de scellement (5b).

15. Procédé selon la revendication 14, plusieurs des composants semiconducteurs (10) étant produits dans un procédé commun, lesquels sont ensuite séparés par sciage.
